# EUROPÄISCHE PATENTSCHRIFT

(11) **EP 3 388 793 B1**
(45) Veröffentlichungstag und Bekanntmachung des Hinweises auf die Patenterteilung: **22.06.2022**
(21) Anmeldenummer: 18162788.6
(22) Anmeldetag: 20.03.2018
(51) Int. Cl.: G01D 21/00, G06F 13/40, H03K 19/0175, G05B 19/042

(54) **ELEKTRONISCHE BAUGRUPPE FÜR PERIPHERIEGERÄTE EINES FLUGGERÄTS**
ELECTRONIC ASSEMBLY FOR PERIPHERAL DEVICES OF AN AIRCRAFT
MODULE ÉLECTRONIQUE POUR APPAREILS PÉRIPHÉRIQUES D'UN AÉRONEF

(30) Priorität: 13.04.2017 DE 102017003660
(43) Veröffentlichungstag der Anmeldung: 17.10.2018
(73) Patentinhaber: Liebherr-Aerospace Lindenberg GmbH, 88161 Lindenberg/Allgäu (DE)
(72) Erfinder: Fink, Cornelius, 6932 Langen (AT); Immler, Thomas, 88138 Sigmarszell (DE)
(74) Vertreter: Herrmann, Uwe

(56) Entgegenhaltungen:
- EP-A1- 3 154 151
- EP-A2- 1 712 968
- CN-U- 202 008 597
- US-A1- 2004 054 821
- US-A1- 2011 227 556
- US-A1- 2012 197 473
- US-A1- 2015 378 960
- Anonymous: "Programmieren lernen am Raspberry Pi: GPIO Pins steuern", , 1 January 2017 (2017-01-01), XP055839471, Retrieved from the Internet: URL:https://tutorials-raspberrypi.de/raspb erry-pi-gpio-erklaerung-beginner-programmi erung-lernen/ [retrieved on 2021-09-09]

## Beschreibung

Die Erfindung betrifft eine elektronische Baugruppe eines elektronischen Geräts, welche Peripheriegeräte wie beispielsweise Sensoren oder Aktuatoren eines Fluggeräts koppelt. Die Baugruppe umfasst drei voneinander verschiedene generische Schnittstellen zum Koppeln der Baugruppe mit wenigstens einem Peripheriegerät und wenigstens eine, insbesondere nachgelagerte digitale Auswerteinheit, wobei die Baugruppe über wenigstens eine Schnittstelle mit dem Peripheriegerät koppelbar ist.

Die Baugruppe kann vorzugsweise ein Modul sein, das in einer Remote Elektronik angewendet wird bzw. als Teil einer Remote Elektronik ausgebildet und/oder mit einer solchen gekoppelt ist. Denkbar ist ferner, dass die Baugruppe in einem anderen Gerät bzw. in einer anderen Einrichtung eines Fluggeräts angewendet wird bzw. als Teil einer entsprechenden Einrichtung ausgebildet ist.

Aus dem Stand der Technik sind elektronische Fernbedienungsteile bzw. Remote Electronic Units (REU) bekannt, die dazu dienen, bei Fluggeräten eine dezentrale System-Architektur insbesondere im Flugsteuerungs- und Fahrwerksbereich zu ermöglichen. Dabei ist es erforderlich, dass die Fernbedienungsteile bzw. entsprechenden Baugruppen der Fernbedienungsteile eine Vielzahl an verschiedenen Sensoren bzw. Aktuatoren einlesen bzw. ansteuern können.

Die EP 1 712 968 A2, die CN 202 008 597 U, die EP 3 154 151 A1, die US 2004/054821 A1, die US 2012/197473 A1, die US 2011/227556 A1 und die US 2015/378960 A1 offenbaren Gegenstände oder Verfahren, die Stand der Technik für die vorliegende Erfindung bilden.

Die Vielzahl unterschiedlicher Peripheriegeräte führt dazu, dass eine entsprechende Vielzahl passender Schnittstellen bereitgestellt werden muss, was die Fernbedienungsteile und somit auch die angestrebte dezentrale System-Architektur und sowie deren Entwicklung teuer und aufwändig macht.

Darüber hinaus ist die Wiederverwendung der Fernbedienungsteile nachteiligerweise sehr eingeschränkt, da für die jeweilige Anwendung des Fernbedienungsteils dessen Elektronik maßgeschneidert ist und damit schlecht mit anderen Peripheriegeräten koppelbar ist. Da gemäß aktuellen Konzepten in Abhängigkeit des einzulesenden bzw. des zu erzeugenden Signals eine dezidierte Schnittstelle entwickelt und verwendet wird, muss somit eine entsprechende Vielzahl verschiedener Schnittstellen zur Ausführung der dezentralen System-Architektur bereitgestellt werden.

Vor diesem Hintergrund ist es Aufgabe der Erfindung die Anzahl der verschiedenen notwendigen Schnittstellen eines Fernbedienungsteils auf ein Minimum zu reduzieren, wobei gleichzeitig dieselbe Fernbedienungshardware für verschiedene Funktionen verwendet werden kann.

Diese Aufgabe wird erfindungsgemäß durch eine elektronische Baugruppe für Peripheriegeräte wie Sensoren oder Aktuatoren eines Fluggeräts mit den Merkmalen des Anspruchs 1 gelöst. Vorteilhafte Ausgestaltungen sind Gegenstand der

Demnach ist eine Baugruppe mit wenigstens drei voneinander verschiedenen generischen Schnittstellen zum Koppeln der Baugruppe mit wenigstens einem Peripheriegerät und wenigstens einer insbesondere nachgelagerten digitalen Auswerteeinheit vorgesehen. Die Baugruppe kann über wenigstens eine Schnittstelle mit dem Peripheriegerät koppelbar sein. Erfindungsgemäß ist vorgesehen, dass eine Schnittstelle ein digitaler Ausgang mit insbesondere optionalem Feedback, eine Schnittstelle ein analoger Ausgang und eine Schnittstelle ein analoger Eingang ist. Die nachgelagerte digitale Auswerteeinheit kann als Nachregelung ausgebildet sein.

Durch die mit einer derartigen Baugruppe geschaffene gesteigerte Flexibilität wird die Möglichkeit zur Wiederverwendung des Fernbedienungsteils bzw. der Baugruppe vorteilhafterweise erhöht und dadurch der Entwicklungsaufwand bei zukünftigen Projekten gespart.

In einer bevorzugten Ausführung ist denkbar, dass der digitale Ausgang dazu eingerichtet ist, Signale mit variabler Pulsbreite, Signale mit variabler Frequenz und/oder Signale zur Anregung von Sensoren auszugeben und/oder eine Rückführung von Signalen zur Schaltzustandsverifizierung durchzuführen und/oder bei einer Rückführung von Signalen als digitaler Eingang verwendet zu werden. Der digitale Ausgang kann somit in einer bevorzugten Ausführung so ausgebildet sein, dass er auch als digitaler Eingang funktionieren kann.

In einer weiteren bevorzugten Ausführung ist denkbar, dass der analoge Ausgang dazu eingerichtet ist, ein Signal mit variabler Spannung und/oder Frequenz und/oder Signalform auszugeben. Die Signalform kann dabei vorzugsweise ein sinusförmiges Signal, ein rechteckförmiges Signal oder sonstige Signalformen umfassen.

In einer weiteren bevorzugten Ausführung ist denkbar, dass der analoge Eingang dazu eingerichtet ist, eine Strommessung, eine Spannungsmessung, eine Frequenzmessung, eine Widerstandsmessung und/oder eine digitale Zustandsmessung durchzuführen.

In einer weiteren bevorzugten Ausführung ist ferner denkbar, dass das Peripheriegerät ein LVDT bzw. ein Differenzialtransformator, ein RVDT bzw. ein Drehmelder, ein Resolver bzw. ein Koordinatenwandler oder Winkellagegeber, ein passiver induktiver Näherungssensor, ein Servoventil, ein Potentiometer, ein Magnetventil, ein Analogsensor, ein Temperatursensor und/oder ein Drucksensor ist. Dabei kann vorgesehen sein, dass jeweils nur ein einzelnes Peripheriegerät oder auch mehr als ein einzelnes Peripheriegerät mit der Baugruppe koppelbar ist. In einer weiteren bevorzugten Ausführung ist denkbar, dass die digitale Auswerteeinheit ein FPGA oder ein Microcontroller ist.

In einer weiteren bevorzugten Ausführung kann vorgesehen sein, dass der LVDT, der Resolver, der passive induktive Näherungssensor und/oder das Servoventil über den analogen Ausgang und den analogen Eingang mit der Baugruppe koppelbar sind. Alternativ kann vorgesehen sein, dass das Servoventil nur über den analogen Ausgang mit der Baugruppe koppelbar ist. Es kann vorgesehen sein, dass dabei der digitale Ausgang nicht zur Kopplung der Baugruppe mit den genannten Peripheriegeräten verwendet wird.

In einer weiteren bevorzugten Ausführung kann vorgesehen sein, dass der passive induktive Näherungssensor, der Analogsensor und/oder der Temperatursensor über den digitalen Ausgang und den analogen Eingang mit der Baugruppe koppelbar sind. Hierbei kann vorgesehen sein, dass der analoge Ausgang nicht zur Kopplung der genannten Peripheriegeräte genutzt wird.

Erfindungsgemäß ist vorgesehen, dass die Baugruppe über Pin-Programmierung konfigurierbar ist.

Erfindungsgemäß ist vorgesehen, dass der analoge Ausgang einen Tiefpassfilter und einen Verstärker umfasst, 2. und dass die digitale Auswerteeinheit einen PDM-Modulator umfasst.

Weitere Einzelheiten und Vorteile der Erfindung sind anhand der in den Figuren dargestellten Ausführungen erläutert. Dabei zeigen:
- Fig. 1:: eine schematische Ansicht der Möglichkeiten der Kopplung der erfindungsgemäßen Baugruppe mit unterschiedlichen Peripheriegeräten; und
- Fig. 2:: eine schematische Ansicht der Kopplung der erfindungsgemäßen Baugruppe mit einem Servoventil.

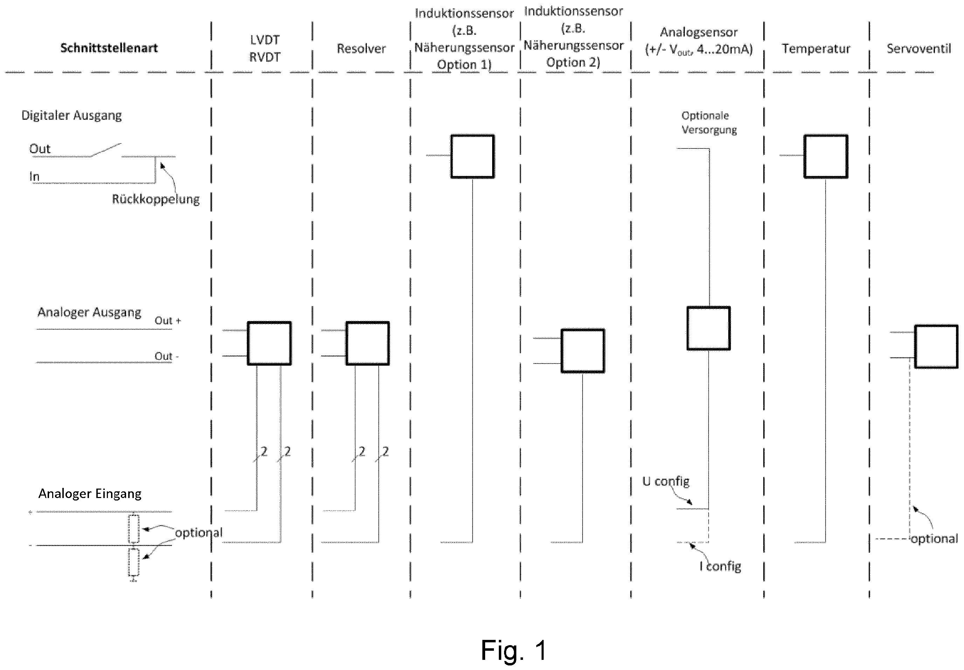

Figur 1 zeigt im linken Bereich die schematisch dargestellten, voneinander verschiedenen drei Schnittstellen der Baugruppe. Rechts davon sind ebenfalls schematisch unterschiedliche Peripheriegeräte angegeben.

Bei den Peripheriegeräten kann es sich um Sensoren oder Aktuatoren des Fluggeräts handeln, die über die Baugruppe mit beispielsweise einem Bordrechner des Fluggeräts koppelbar sind.

Zu jedem der Peripheriegeräte ist durch entsprechende vertikale Positionierung von dessen Kopplungsstellen im Bereich des digitalen Ausgangs, des analogen Ausgangs und/oder des analogen Eingangs angezeigt, wie dieses mit der Baugruppe koppelbar ist.

Die Peripheriegeräte sind in dem Ausführungsbeispiel der Figur 1 überwiegend über jeweils genau zwei der drei Schnittstellen mit der Baugruppe gekoppelt. Wie im rechten Bereich der Figur 1 gezeigt, kann das beispielhaft beschriebene Servoventil allein über den analogen Ausgang mit der Baugruppe gekoppelt sein. Optional besteht die Möglichkeit, das Servoventil sowohl über den analogen Ausgang als auch über den analogen Eingang mit der Baugruppe zu koppeln. Andere Peripheriegeräte können über genau zwei der drei Schnittstellen mit der Baugruppe koppelbar sein.

Bei einer Kopplung der erfindungsgemäßen Baugruppe mit einem Analogsensor kann vorgesehen sein, dass der Analogsensor über den digitalen Ausgang versorgt wird. Je nachdem, ob eine Spannung oder eine Stromstärke des Analogsensors erfasst werden soll, kann der Analogsensor mit unterschiedlichen Polen des analogen Eingangs koppelbar sein.

Mit der Verwendung von nur drei verschiedenen generischen Schnittstellen sowie einer nachgelagerten digitalen Auswertung mittels einer Auswerteeinheit 7 bzw. einer Nachregelung 7 ist es möglich, eine Vielzahl verschiedenster Sensoren einzulesen und auszuwerten bzw. elektronische Steuerelemente und Aktuatoren anzusteuern. Die Zuordnung einer Funktion wie beispielsweise eine LVDT-Auswertung zu den generischen Schnittstellen kann über einen FTGA oder einen Microcontroller erfolgen.

Durch vordefinierte Funktionen und einfache Konfigurationen über PIN-Programmierung, kann der FTGA bzw. Microcontroller in Verbindung mit den oben genannten Schnittstellen als universell einsetzbare Auswerte- und Steuereinheit verwendet werden.

Mittels der vorliegend beschriebenen Erfindung kann ein universell einsetzbarer Remote Electronic Data Concentrator ausgeführt werden. Eine weitere beispielhafte Ausführung umfasst die Implementierung der Erfindung mit einem Flight Control Computer, der einen oder mehrere Sensoren wie beispielsweise Resolver, RVDT, Potentiometer, Temperatursensoren, induktive Näherungsschalter mithilfe der beschriebenen Schnittstellen auswertet.

Ein weiteres mögliches Ausführungsbeispiel umfasst die Auswertung von passiven induktiven Näherungssensoren für Luftfahrtanwendungen unter der Verwendung der vorliegend beschriebenen Erfindung. Ein anderes mögliches Ausführungsbeispiel umfasst die Ansteuerung von Servoventilen unter der Verwendung der vorliegend beschriebenen universellen Schnittstellen.

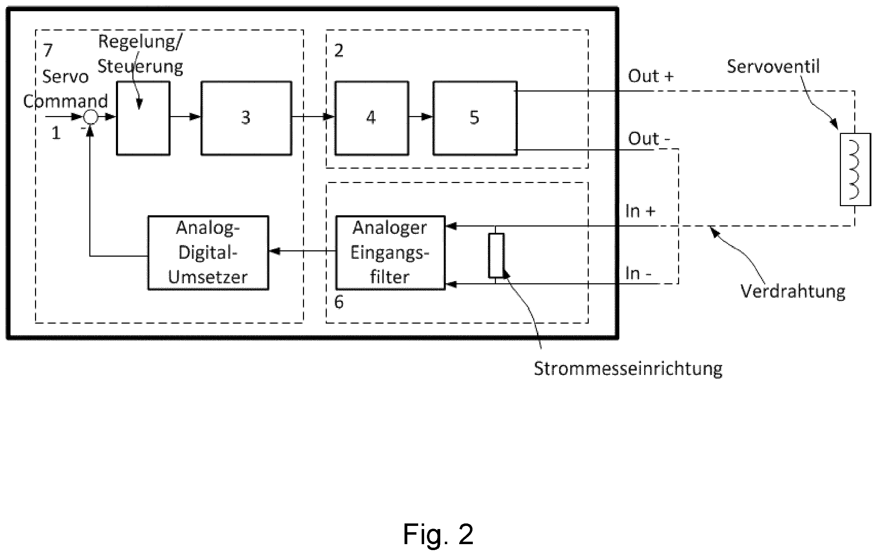

Wie in Figur 2 gezeigt erzeugt der analoge Ausgang 2 erfindungsgemäß eine differentielle Spannung, die hinsichtlich Frequenz und Amplitude variabel ist. Hierbei wird erfindungsgemäß ein hochfrequentes PDM (pulse density modulation) moduliertes Signal mittels eines entsprechenden PDM-Modulators 3 erzeugt, welches tiefpassgefiltert und verstärkt wird. Hierdurch kann eine gewünschte Signalform rekonstruiert werden. Durch eine Strommessung kann der Strom durch das angeschlossene Ventil ermittelt werden und mittels einer Nachregelung bzw. Auswerteeinheit 7 des PDM-Signals der kommandierte Strom 1 eingestellt werden.

Der analoge Ausgang 2 umfasst erfindungsgemäß wenigstens einen in Serie mit wenigstens einem Verstärker 5 geschalteten Filter 4. Der analoge Eingang 6 kann einen analogen Eingangsfilter umfassen, der insbesondere parallel mit einer Strommesseinrichtung geschaltet sein kann.

Die Nachregelung 7 bzw. die Auswerteeinheit 7 kann eine Regelung/Steuerung umfassen, die in Serie mit dem PDM-Modulator 3 geschaltet sein kann. Die Nachregelung 7 kann ferner über einen Analog-Digital-Umsetzter mit dem Analogeingang 6 gekoppelt sein.

Als Vorteile der erfindungsgemäßen Vorrichtung ergeben sich deren universelle Einsetzbarkeit in Verbindung mit unterschiedlichen Peripheriegeräten. Dabei kann die Baugruppe auch einfacher mit unterschiedlichen Peripheriegeräten wiederverwendet werden.

Ferner ergibt sich eine Reduktion der Anzahl und Komplexität der Hardwarekomponenten, was zu entsprechenden Kosten- und Gewichtsvorteilen führt.

Durch Verwendung dreier generischer Schnittstellen ergibt sich für das System des Fluggeräts insgesamt eine Reduktion der Anzahl von verschiedenen benötigten Schnittstellen. Dies führt ebenfalls zu entsprechenden Kostenreduktionen.

Je nach Ausführung der Baugruppe können ferner ein reduzierter Platzbedarf der Vorrichtung erreicht werden und es kann durch die Beschränkung auf drei Schnittstellen der Entwicklungsaufwand zur Entwicklung neuer, mittels der Baugruppe steuerbarer bzw. anschließbarer Peripheriegeräte reduziert werden.

## Patentansprüche

1. Elektronische Baugruppe zum Koppeln von Peripheriegeräten wie Sensoren und/oder Aktuatoren eines Fluggeräts, umfassend:
drei voneinander verschiedene generische Schnittstellen zum Koppeln der Baugruppe mit wenigstens einem Peripheriegerät, und
eine digitale Auswerteeinheit (7), wobei
eine erste der drei Schnittstellen ein digitaler Ausgang mit insbesondere optionalem Feedback,
eine zweite der drei Schnittstellen ein analoger Ausgang (2) ist, und
eine dritte der drei Schnittstellen ein analoger Eingang (6) ist,
**dadurch gekennzeichnet, dass**
die Baugruppe über Pin-Programmierung konfigurierbar ist, und
der analoge Ausgang (2) einen in Serie mit einem Verstärker (5) geschalteten Tiefpassfilter (4) umfasst,
die digitale Auswerteeinheit (7) einen Pulse Density Modulation PDM-Modulator (3) umfasst, wobei der analoge Ausgang (2) dazu eingerichtet ist, eine differentielle Spannung zu erzeugen, die hinsichtlich Frequenz und Amplitude variabel ist, wobei ein mittels des PDM-Modulators (3) hochfrequentes pulse density modulation moduliertes Signal mittels dem Filter (4) tiefpassgefiltert und mittels dem Verstärker (5) verstärkt wird.

2. Elektronische Baugruppe nach Anspruch 1, **dadurch gekennzeichnet, dass** der digitale Ausgang dazu eingerichtet ist, Signale mit variabler Pulsbreite und/oder Signale mit variabler Frequenz auszugeben.

3. Elektronische Baugruppe nach Anspruch 1 oder 2, wobei der digitale Ausgang dazu eingerichtet ist eine Rückführung von Signalen zur Schaltzustandsverifizierung durchzuführen und dabei als digitaler Eingang verwendet zu werden.

4. Elektronische Baugruppe nach einem der vorhergehenden Ansprüche, **dadurch gekennzeichnet, dass** der analoge Ausgang (2) dazu eingerichtet ist, ein Signal mit variabler Spannung, Frequenz und/oder Form auszugeben.

5. Elektronische Baugruppe nach einem der vorhergehenden Ansprüche, **dadurch gekennzeichnet, dass** der analoge Eingang (6) dazu eingerichtet ist, eine Strommessung, eine Spannungsmessung, eine Frequenzmessung, eine Widerstandsmessung und/oder eine digitale Zustandsmessung durchzuführen.

6. Elektronische Baugruppe nach einem der vorhergehenden Ansprüche, **dadurch gekennzeichnet, dass** das Peripheriegerät ein LVDT, ein RVDT, ein Resolver, ein passiver induktiver Näherungssensor, ein Servoventil, ein Potentiometer, ein Magnetventil, ein Analogsensor, ein Temperatursensor und/oder ein Drucksensor ist.

7. Elektronische Baugruppe nach einem der vorhergehenden Ansprüche, **dadurch gekennzeichnet, dass** die digitale Auswerteeinheit (7) ein FPGA oder ein Microcontroller ist.

8. Elektronische Baugruppe wenigstens nach Anspruch 6, **dadurch gekennzeichnet, dass** der analoge Ausgang (2) und der analoge Eingang (6) dazu ausgelegt sind, ein Peripheriegerät in Form des LVDT, des Resolvers, des passiven induktiven Näherungssensors und/oder des Servoventils zu koppeln.

9. Elektronische Baugruppe wenigstens nach Anspruch 6, **dadurch gekennzeichnet, dass** der analoge Ausgang (2) und der analoge Eingang (6) dazu ausgelegt sind, ein Peripheriegerät in Form des Servoventils nur über den analogen Ausgang (2) mit der Baugruppe zu koppeln.

10. Elektronische Baugruppe wenigstens nach Anspruch 6, **dadurch gekennzeichnet, dass** der digitale Ausgang und der analoge Eingang (6) dazu ausgelegt sind, das Peripheriegerät in Form des passiven induktiven Näherungssensors, des Analogsensors und/oder des Temperatursensors zu koppeln.

## Claims

1. An electronic assembly for coupling peripheral devices such as sensors and/or actuators of an aircraft comprising:
three generic interfaces differing from one another for coupling the assembly to at least one peripheral device; and
a digital evaluation unit (7), wherein
a first one of the three interfaces is a digital output with feedback, in particular optional feedback;
a second one of the three interfaces is an analog output (2); and
a third one of the three interfaces is an analog input (6),
**characterized in that**
the assembly is configurable via pin programming; and
the analog output (2) comprises a low pass filter (4) connected in series to an amplifier (5);
the digital evaluation unit (7) comprises a pulse density modulation, PDM, modulator (3),
with the analog output (2) being adapted to generate a differential voltage that is variable with respect to frequency and amplitude; and
with a high frequency pulse density modulation signal modulated by means of the PDM modulator (3) being low pass filtered by means of the filter (4) and being amplified by means of the amplifier (5).

2. An electronic assembly in accordance with claim 1, **characterized in that** the analog output is adapted to output signals having a variable pulse width and/or signals having variable frequency.

3. An electronic assembly in accordance with claim 1 or claim 2, **characterized in that** that the digital output is adapted to carry out a feedback of signals for a switching state verification and to be used as a digital input in this respect.

4. An electronic assembly in accordance with one of the preceding claims, **characterized in that** the analog output (2) is adapted to output a signal having a variable voltage, frequency, and/or shape.

5. An electronic assembly in accordance with one of the preceding claims, **characterized in that** the analog input (6) is adapted to carry out a current measurement, a voltage measurement, a frequency measurement, a resistance measurement, and/or a digital status measurement.

6. An electronic assembly in accordance with one of the preceding claims, **characterized in that** the peripheral device is an LVDT, an RVDT, a resolver, a passive inductive proximity sensor, a servo valve, a potentiometer, a solenoid valve, an analog sensor, a temperature sensor. and/or a pressure sensor.

7. An electronic assembly in accordance with one of the preceding claims, **characterized in that** the digital evaluation unit (7) is an FPGA or a microcontroller.

8. An electronic assembly at least in accordance with claim 6, **characterized in that** the analog output (2) and the analog input (6) are configured to couple a peripheral device in the form of the LVDT, the resolver, the passive inductive proximity sensor, and/or the servo valve.

9. . An electronic assembly at least in accordance with claim 6, **characterized in that** the analog output (2) and the analog input (6) are configured to couple a peripheral device in the form of the servo valve to the assembly only via the analog output (2).

10. An electronic assembly at least in accordance with claim 6, **characterized in that** the digital output and the analog input (6) are configured to couple the peripheral device in the form of the passive inductive proximity sensor, the analog sensor, and/or the temperature sensor.

## Revendications

1. Module électronique destiné au couplage d'appareils périphériques tels que des capteurs et/ou actionneurs d'un aéronef, comprenant :
trois interfaces génériques différentes les unes des autres pour coupler le module à au moins un appareil périphérique, et
une unité d'évaluation numérique (7), dans lequel
une première des trois interfaces est une sortie numérique avec en particulier un retour d'information en option,
une deuxième des trois interfaces est une sortie analogique (2), et
une troisième des trois interfaces est une entrée analogique (6),
**caractérisé en ce que**
le module peut être configuré par le biais d'une programmation de broche, et
la sortie analogique (2) comprend un filtre passe-bas (4) monté en série avec un amplificateur (5),
l'unité d'évaluation (7) comprend un modulateur PDM, Pulse Density Modulation (modulation de densité d'impulsion), (3),
la sortie analogique (2) étant configurée pour générer une tension différentielle qui est variable en ce qui concerne la fréquence et l'amplitude,
un signal à haute fréquence modulé par modulation de densité d'impulsion au moyen du modulateur PDM (3) étant filtré par filtre passe-bas au moyen du filtre (4) et amplifié au moyen de l'amplificateur (5).

2. Module électronique selon la revendication 1, **caractérisé en ce que** la sortie numérique est configurée pour délivrer des signaux avec une largeur d'impulsion variable et/ou des signaux avec une fréquence variable.

3. Module électronique selon la revendication 1 ou 2, dans lequel la sortie numérique est configurée pour effectuer un retour de signaux pour la vérification de l'état de commutation et être alors utilisée comme entrée numérique.

4. Module électronique selon l'une des revendications précédentes, **caractérisé en ce que** la sortie analogique (2) est configurée pour délivrer un signal avec une tension, une fréquence et/ou une forme variables.

5. Module électronique selon l'une des revendications précédentes, **caractérisé en ce que** l'entrée analogique (6) est configurée pour effectuer une mesure de courant, une mesure de tension, une mesure de fréquence, une mesure de résistance et/ou une mesure d'état numérique.

6. Module électronique selon l'une des revendications précédentes, **caractérisé en ce que** l'appareil périphérique est un LVDT, un RVDT, un résolveur, un capteur de proximité inductif passif, une servovalve, un potentiomètre, une électrovalve, un capteur analogique, un capteur de température et/ou un capteur de pression.

7. Module électronique selon l'une des revendications précédentes, **caractérisé en ce que** l'unité d'évaluation numérique (7) est un FPGA ou un m icrocontrôleur.

8. Module électronique au moins selon la revendication 6, **caractérisé en ce que** la sortie analogique (2) et l'entrée analogique (6) sont conçues pour coupler un appareil périphérique sous la forme du LVDT, du résolveur, du capteur de proximité inductif passif et/ou de la servovalve.

9. Module électronique au moins selon la revendication 6, **caractérisé en ce que** la sortie analogique (2) et l'entrée analogique (6) sont conçues pour coupler un appareil périphérique sous la forme de la servovalve au module uniquement par le biais de la sortie analogique (2).

10. Module électronique au moins selon la revendication 6, **caractérisé en ce que** la sortie numérique et l'entrée analogique (6) sont conçues pour coupler l'appareil périphérique sous la forme du capteur de proximité inductif passif, du capteur analogique et/ou du capteur de température.
